# EUROPÄISCHE PATENTSCHRIFT

(11) **EP 4 078 108 B1**
(45) Veröffentlichungstag und Bekanntmachung des Hinweises auf die Patenterteilung: **11.06.2025**
(21) Anmeldenummer: 19835405.2
(22) Anmeldetag: 20.12.2019
(51) Int. Cl.: G01F 23/00, G01L 19/00, G01N 9/00

(54) **AUTARKE SENSORVORRICHTUNG MIT ERWEITERUNGSMODULEN**
AUTONOMOUS SENSOR DEVICE WITH EXPANSION MODULES
DISPOSITIF DE CAPTEUR AUTONOME AVEC DES MODULES D'EXTENSION

(43) Veröffentlichungstag der Anmeldung: 26.10.2022
(73) Patentinhaber: VEGA Grieshaber KG, 77709 Wolfach (DE)
(72) Erfinder: WELLE, Roland, 77756 Hausach (DE); BÖRSIG, Jörg, 77709 Oberwolfach (DE); WÄLDE, Steffen, 78078 Niedereschach (DE)
(74) Vertreter: Maiwald GmbH
(86) Internationale Anmeldenummer: PCT/EP2019/086736
(87) Internationale Veröffentlichungsnummer: WO 2021/121629

(56) Entgegenhaltungen:
- EP-A1- 3 015 847
- EP-A1- 3 349 047
- WO-A1-2017/103887
- DE-A1- 102015 112 536
- US-A1- 2019 195 717
- US-A1- 2019 250 019

## Beschreibung

Die Erfindung betrifft eine Sensorvorrichtung zur Prozessgrößenermittlung im industriellen Umfeld mit einer Sensorbasiseinheit und Erweiterungsmodulen.

### Hintergrund der Erfindung

Zur Erfassung von industriellen Prozessgrößen, z.B. in chemischem Umfeld kann es notwendig sein, dass der Sensor zur Erfassung einer Prozessgröße hermetisch geschlossen sein muss. Hierzu können autarke Sensoren verwendet werden. Da diese von einem abgeschlossen Gehäuse umgeben sind, können sie nicht ohne Weiteres mit neuen Funktionalitäten durch beispielsweise den Einbau zusätzlicher Hardware ausgestattet werden. Somit ist es beispielsweise nicht möglich, nachträglich eine Anzeige- und Bedienfunktion, Datenspeicher oder leistungsfähigere Energiespeicher einzubauen.

Entsprechend werden für die unterschiedlichsten Kundenanforderungen autark arbeitende Füllstandsensoren kundenspezifisch entwickelt, was eine hohe Zahl an Sensorvarianten nach sich zieht. Im Hinblick auf die dadurch entstehenden Kosten für Entwicklung, Zulassung, Fertigung und Vertrieb ist diese hohe Zahl unterschiedlicher Geräte von großem Nachteil. Zudem können die Geräte nicht nachträglich mit zusätzlichen Funktionen ausgestattet werden.

Die WO 2017/103887 A1 beschreibt eine Aerosolabgabevorrichtung, bei der der Steuerkörper mit einer Kartusche gekoppelt oder koppelbar ist. Die US 2019/195717 A1 beschreibt einen Inline-Sensor mit einem Gehäuse, das in einer Wand einer Flüssigkeitsleitung oder einem Prozessbehälter befestigt werden kann. Die US 2019/250019 A1 beschreit einen modularen Bausatz für eine Feldvorrichtung mit austauschbaren Komponenten. Die EP 3015847 A1 beschreibt ein Messgerät zur Dichtemessung von fluiden Medien mit einem Dichtesensor, wobei eine Mess- und Sensorelektronik mit einem Gehäuse oder einer Kartusche umschlossen werden. Die EP 3349047 A1 beschreibt ein Modulsystem für ein radiometrisches Messgerät ein Basismodul, mit einer Sensoranordnung und einem Erweiterungsmodul, wobei das Basismodul auf einer ersten Leiterplatine und das Erweiterungsmodul auf einer zweiten Leiterplatine realisiert sein kann. Die DE 102015112536 A1 beschreibt ein optoelektronisches Steckmodul.

### Zusammenfassung der Erfindung

Es ist daher eine Aufgabe der Erfindung, ein Konzept und darauf angepasste erfindungsgemäße Vorrichtungen vorzugschlagen, welche die zuvor genannten Nachteile beseitigen.

Die Aufgabe wird durch den Gegenstand des unabhängigen Patentanspruchs 1 gelöst. Vorteilhafte Ausführungsformen sind Gegenstand der abhängigen Ansprüche, der folgenden Beschreibung, sowie der Figuren.

Erfindungsgemäß wird eine Sensorvorrichtung mit einer Sensorbasiseinheit zur Prozessgrößenermittlung im industriellen Umfeld bereitgestellt. Die Sensorbasiseinheit weist eine erste drahtlose Kommunikationseinheit auf, die zum Senden von Signalen zu einem ersten Erweiterungsmodul und / oder Empfangen von Signalen von einem ersten Erweiterungsmodul eingerichtet ist, sowie ein erstes Gehäuse mit einer ersten Aufnahmevorrichtung, die zum Aufnehmen des ersten Erweiterungsmoduls oder eines zweiten Gehäuses eingerichtet ist, wobei das erste Gehäuse die Sensorbasiseinheit vollständig umschließt.

Unter dem Begriff "Prozessautomatisierung im industriellen Umfeld" kann ein Teilgebiet der Technik verstanden werden, welches alle Maßnahmen zum Betrieb von Maschinen und Anlagen ohne Mitwirkung des Menschen beinhaltet. Ein Ziel der Prozessautomatisierung ist es, das Zusammenspiel einzelner Komponenten einer Werksanlage in den Bereichen Chemie, Lebensmittel, Pharma, Erdöl, Papier, Zement, Schifffahrt oder Bergbau zu automatisieren. Hierzu können eine Vielzahl an Sensoren eingesetzt werden, welche insbesondere an die spezifischen Anforderungen der Prozessindustrie, wie bspw. mechanische Stabilität, Unempfindlichkeit gegenüber Verschmutzung, extremen Temperaturen und extremen Drücken, angepasst sind. Messwerte dieser Sensoren werden üblicherweise an eine Leitwarte übermittelt, in welcher Prozessparameter wie Füllstand, Grenzstand, Durchfluss, Druck oder Dichte überwacht und Einstellungen für die gesamte Werksanlage manuell oder automatisiert verändert werden können.

Ein Teilgebiet der Prozessautomatisierung im industriellen Umfeld betrifft die Logistikautomation. Mit Hilfe von Distanz- und Winkelsensoren werden im Bereich der Logistikautomation Abläufe innerhalb eines Gebäudes oder innerhalb einer einzelnen Logistikanlage automatisiert. Typische Anwendungen finden z.B. Systeme zur Logistikautomation im Bereich der Gepäck- und Frachtabfertigung an Flughäfen, im Bereich der Verkehrsüberwachung (Mautsysteme), im Handel, der Paketdistribution oder aber auch im Bereich der Gebäudesicherung (Zutrittskontrolle). Gemein ist den zuvor aufgezählten Beispielen, dass eine Präsenzerkennung in Kombination mit einer genauen Vermessung der Größe und der Lage eines Objektes von der jeweiligen Anwendungsseite gefordert wird.

Hierfür können Sensoren auf Basis optischer Messverfahren mittels Laser, LED, 2D-Kameras oder 3D-Kameras, die nach dem Laufzeitprinzip (time of flight, ToF) Abstände erfassen, verwendet werden.

Ein weiteres Teilgebiet der Prozessautomatisierung im industriellen Umfeld betrifft die Fabrik-/Fertigungsautomation. Anwendungsfälle hierzu finden sich in den unterschiedlichsten Branchen wie Automobilherstellung, Nahrungsmittelherstellung, Pharmaindustrie oder allgemein im Bereich der Verpackung. Ziel der Fabrikautomation ist, die Herstellung von Gütern durch Maschinen, Fertigungslinien und/oder Roboter zu automatisieren, d. h. ohne Mitwirkung des Menschen ablaufen zu lassen. Die hierbei verwendeten Sensoren und spezifischen Anforderungen im Hinblick auf die Messgenauigkeit bei der Erfassung der Lage und Größe eines Objektes sind mit denen der im vorigen Beispiel der Logistikautomation vergleichbar.

Unter "Sensor" wird ein Gerät verstanden, das eine Messfühler in einem Gehäuse zum Ermitteln der Prozessgrößen aufweist, sowie der innerhalb des Gehäuses vorhanden Bauteile, wie z.B. Elektronikkomponenten, Anschlüsse und mechanische Elemente.

Die Sensorbasiseinheit ist beispielsweise eingerichtet, als Prozessgröße einen Druck, einen Füllstand, einen Grenzstand oder eine Dichte zu ermitteln.

Die Sensorbasiseinheit wird erfindungsgemäß somit durch die drahtlose Kommunikationseinheit und die drahtlose Energieübertragungseinheit autark betrieben, trotz eines geschlossenen Gehäuses um die Sensorbasiseinheit herum. Durch das geschlossene Gehäuse befinden sich alle funktionalen Teile der Sensorbasiseinheit innerhalb des Gehäuses, d.h. insbesondere auch Prozessgrößenerfassungseinheit einschließlich z.B. der Elektronik und in der Regel auch eine Antenne oder ein Messfühler. Das Erweiterungsmodul kann eine oder mehrere Erweiterungen bereitstellen, wie in den Ausführungsformen unten erläutert wird. Somit kann die Sensorbasiseinheit bzw. der Sensor beliebig modular ohne Eingriff in die Sensorbasiseinheit erweitert werden. Dadurch, dass zum Verbinden der Sensorbasiseinheit mit dem Erweiterungsmodul lediglich eine mechanische Aufnahme vorgesehen ist und keine galvanischen elektrischen Verbindungen mit entsprechenden Verbindungsvorrichtungen, ist die Montage sehr einfach. Eine Draht- oder Steckerverbindung, die eventuell einer Verschmutzung, Korrosion oder Verformung ausgesetzt ist, ist nicht notwendig.

Die mechanische Aufnahme weist beispielsweise ein Gewinde, eine Schnappvorrichtung, ein Klickverschluss, eine magnetische Anordnung oder einen Klettverschluss auf. Das Gewinde kann zum Beispiel ein Innengewinde an einem überstehenden Rand des Gehäuses sein, ein Außengewinde des Gehäuses, oder ein zentrales Schraubengewinde, so dass das Erweiterungsmodul auf das Gehäuse der Sensorbasiseinheit aufgeschraubt werden kann.

Gemäß einer Ausführungsform umschließt das erste Gehäuse die Sensorbasiseinheit hermetisch, so dass keine Luft oder Flüssigkeit eindringen oder austreten kann. Gerade in diesen Fällen, wo das Gehäuse hermetisch dicht sein muss, ist es wichtig, mechanische Beanspruchungen an Schnittstellen nach außen gering zu halten oder zu vermeiden, so dass die Dichtheit bestehen bleibt. Die vorgestellte Sensorbasiseinheit vermeidet derartige Schnittstellen zum Erweiterungsmodul, d.h. Kabel, Stecker, Dichtungen, etc., gänzlich.

Gemäß einer Ausführungsform sind die Signale Mess- und/oder Steuersignale, und die erste drahtlose Kommunikationseinheit ist eingerichtet, die Signale analog oder digital zu senden und / oder zu empfangen. Typischerweise werden analoge Messsignale von einer Prozessgrößenermittlungseinheit in der Sensorbasiseinheit generiert, die vorprozessiert und in digitale Signale gewandelt werden, und als digitale Daten an das Erweiterungsmodul übertragen werden. Die Steuerung, wie z.B. Messzyklus, evtl. Synchronisierung, Konfiguration, Abruf der Daten, etc., erfolgt beispielsweise durch eine Kontrolleinheit eines Erweiterungsmodul. Die Kontrolleinheit kann die Informationen z.B. von außen erhalten. Die Daten können z.B. gemäß einer digital oder analogen Modulationstechnik gemäß einem Kommunikationsprotokoll auf einen Träger moduliert werden. Das Kommunikationsprotokoll unterliegt vorzugsweise einem Kommunikationsstandard.

Gemäß einer Ausführungsform weist die Sensorbasiseinheit alternativ oder zurätzlich zu der ersten drahtlose Kommunikationseinheit eine erste drahtlose Energieübertragungseinheit auf, die eingerichtet ist, Energie zu dem Erweiterungsmodul zu senden und / oder Energie von dem Erweiterungsmodul zu empfangen. Das heißt, eine Energieübertragung ist in beiden Richtungen möglich. Somit kann das Erweiterungsmodul ein Modul ohne eigenen Energiespeicher sein und kann von der Sensorbasiseinheit mit Energie versorgt werden, oder umgekehrt. Es kann auch z.B. zu einem Zeitpunkt die Energie in die eine Richtung übertragen werden und zu einem anderen Zeitpunkt in die andere Richtung, beispielsweise in Abhängigkeit von überschüssiger, bzw. nicht benötigter Energie oder vom Bedarf.

Zur Energieübertragung oder zum Datenabgriff muss das Gehäuse nicht geöffnet werden, und es muss keine dichte Kabelschnittstelle bereitgestellt werden. Die Sensorbasiseinheit kann einen eigenen Energiespeicher, wie z.B. eine Batterie aufweisen, und unterstützend durch ein Erweiterungsmodul Energie erhalten, so dass die Batterie geschont wird und die Lebensdauer verlängert wird. Der optionale Energiespeicher kann auch ein wiederaufladbarer Speicher sein, oder ein Speicher, der nur dann aufgeladen wird, wenn Energie für eine Messung oder für eine Datenübertragung notwendig ist.

Gemäß einer Ausführungsform ist die erste drahtlose Energieübertragungseinheit eingerichtet, elektrische Energie induktiv zu senden und/oder zu empfangen. Als Induktivitäten kommen zum Beispiel Spulen in Betracht, wobei auch die z.B. gedruckten NFC-Antennen als Spulen betrachtet werden. Alternativ kann die Energie elektroakustisch, z.B. übertragen werden, wobei die Wandlung von akustischer zu elektrischer Energie, bzw. umgekehrt, über beispielsweise einen Piezo erfolgt.

Erfindungsgemäß wird weiterhin ein Erweiterungsmodul für die Sensorbasiseinheit zur Prozessgrößenermittlung im industriellen Umfeld bereitgestellt. Das Erweiterungsmodul weist eine zweite drahtlose Kommunikationseinheit auf, die zum Senden von Signalen zu der Sensorbasiseinheit und / oder Empfangen von Signalen von der Sensorbasiseinheit eingerichtet ist, sowie ein zweites Gehäuse mit einer zweiten Aufnahmevorrichtung, die passend zur ersten Aufnahmevorrichtung ausgestaltet ist, so dass das Erweiterungsmodul von der Sensorbasiseinheit aufgenommen werden kann, wobei das zweite Gehäuse das Erweiterungsmodul vollständig umschließt.

Die mechanische Aufnahme des Erweiterungsmoduls, um auf der Sensorbasiseinheit aufgenommen zu werden, ist das Gegenstück zu der mechanischen Aufnahme der Sensorbasiseinheit und ist somit entsprechend ausgestaltet.

Gemäß einer Ausführungsform das zweite Gehäuse eingerichtet, das Erweiterungsmodul hermetisch zu schließen. Beispielsweise ist das Gehäuse des Erweiterungsmoduls mechanisch und bezüglich des Materials so konzipiert, dass es wasserdicht, staubdicht und/oder luftdicht ist. Sowohl die Sensorbasiseinheit als auch das Erweiterungsmodul sind somit derart ausgestaltet dass sie autark arbeiten können, wobei autark bedeuten kann, dass die Sensorbasiseinheit als auch das Erweiterungsmodul für sich genommen autark sind, oder die Kombination der Sensorbasiseinheit mit dem Erweiterungsmodul aufgrund der drahtlosen Verbindungen, wodurch, z.B. die Energie in der Kombination verteilt wird. Gemäß einer weiteren Ausführungsform sind die Signale, die die zweite drahtlose Kommunikationseinheit des Erweiterungsmodul sendet bzw. empfängt, Mess- und/oder Steuersignale. Ferner ist zweite drahtlose Kommunikationseinheit eingerichtet, die Signale analog oder digital zu senden und / oder zu empfangen. Die zweite drahtlose Kommunikationseinheit ist somit korrespondierend zu der ersten drahtlosen Kommunikationseinheit der Sensorbasiseinheit ausgelegt, mit der die zweite drahtlose Kommunikationseinheit kommuniziert.

Gemäß einer Ausführungsform weist das Erweiterungsmodul weiterhin eine zweite drahtlose Energieübertragungseinheit auf, die zum Senden von Energie zu der Sensorbasiseinheit und / oder Empfangen von Energie von der Sensorbasiseinheit eingerichtet ist. Die zweite drahtlose Energieübertragungseinheit entspricht also der ersten drahtlosen Energieübertragungseinheit der Sensorbasiseinheit, die die Energie der zweiten drahtlosen Energieübertragungseinheit entsprechend empfängt oder sendet. Die Energie ist beispielsweise eine elektrische oder eine akustische Energie, und die Energieübertragungseinheit ist gemäß einer Ausführungsform eingerichtet, die elektrische Energie induktiv oder akustisch zu senden und/oder zu empfangen.

Erfindungsgemäß weist das zweite Gehäuse eine dritte Aufnahmevorrichtung auf, das zum Aufnehmen eines weiteren Erweiterungsmoduls eingerichtet ist. Die dritte Aufnahmevorrichtung kann zu der ersten unterschiedlich sein, wird aber vorzugsweise gleich ausgeführt, beispielsweise als ein Gewinde, ein Schnappverschluss, ein Klickverschluss, eine magnetische Anordnung oder einen Klettverschluss. Durch die dritte Aufnahmevorrichtung kann ein weiteres Erweiterungsmodul über das erste Erweiterungsmodule an die Sensorbasiseinheit angeschlossen werden. Angeschlossen heißt dabei, dass auch dieses Erweiterungsmodul, das ebenfalls zumindest eine drahtlose Kommunikationseinheit und gegebenenfalls eine drahtlose Energieübertragungseinheit aufweist, Energie und / oder Signale an die Sensorbasiseinheit senden kann, bzw. von dieser empfangen kann. Somit lassen sich beliebig viele Erweiterungsmodule als ein Stapel von Erweiterungsmodulen auf der Sensorbasiseinheit montieren und bezüglich der Energieübertragung und der Signalübertragung an die Sensorbasiseinheit anschließen.

Damit ist eine variable, modulare Konfiguration des Sensors möglich. Die Erweiterungsmodule können hierbei eingerichtet sein, miteinander zu kommunizieren und z.B. Energie für ein anderes Erweiterungsmodul zur Verfügung zu stellen. Ein Erweiterungsmodul kann ein finales, also ein oberstes Modul sein, an das kein weiteres Erweiterungsmodul mehr angeschlossen werden kann, wie zum Beispiel ein Anzeige- und Bedienmodul, bei dem das Display und die Bedieneinheiten einem Nutzer zugänglich sein müssen.

Wie im Folgenden beschrieben, weisen die Erweiterungsmodule unterschiedliche Baugruppen, Bauteile, Schnittstellen, Funktionalitäten etc. auf. Nachfolgend werden zwar spezifische Ausführungen vorgestellt, aber ein Erweiterungsmodul kann auch eine Kombination verschiedener Modultypen der nachfolgenden Ausführungsformen oder von Teilen davon aufweisen.

Gemäß einer Ausführungsform ist das Erweiterungsmodul als Energiemodul eingerichtet, das mindestens einen Energiespeicher aufweist. Beispielsweise enthält das Energiemodul eine oder mehrere Batterien als Energiespeicher. Somit kann die Sensorbasiseinheit mit ausreichend Energie versorgt werden. Das Modul kann auch eine Schaltung aufweisen, die feststellt, dass der Energievorrat sich dem Ende neigt und eine Anzeige aufweisen, die diesen Zustand anzeigt. Weist die Sensorvorrichtung weiterhin eine externe Kommunikationseinheit auf, kann der Zustand z.B. an einen Server oder ein Smartphone übertragen werden, und das Energiemodul kann zum erforderlichen Zeitpunkt auf einfache Weise ausgetauscht werden, ohne dass das die Sensorbasiseinheit und/oder das Energiemodul geöffnet werden muss, und ohne dass die Sensorbasiseinheit zur Wartung entfernt werden muss. Ist das Erweiterungsmodul ein Zwischenmodul zwischen der Sensorbasiseinheit und einem weiteren Erweiterungsmodul, kann das Erweiterungsmodul konfiguriert sein, Energie an das weitere Erweiterungsmodul zu übertragen. Ferner kann der Energiespeicher ein wiederaufladbarer Energiespeicher sein, so dass das Erweiterungsmodul von dem Sensorbasismodul oder einem weiteren Erweiterungsmodul Energie erhält, speichern und wieder abgeben kann.

Gemäß einer Ausführungsform ist das Erweiterungsmodul als Extern-Kommunikationsmodul eingerichtet und weist eine dritte Kommunikationseinheit auf. Die externe Kommunikation kann beispielsweise gemäß einem oder mehreren der Standards WLAN, 5G, Bluetooth, Zigbee, NB-IOT, GSM, CAT-M, LoRa, Sigfox oder anderen Protokollen zur Datenübertragung erfolgen. Die Kommunikationseinheit kann auch eine drahtgebundene Verbindung, z.B. eine Feldbusverbindung unterstützen und das Erweiterungsmodul die entsprechende Hardware und Software, wie zum Beispiel auch eine entsprechende Steckverbindung oder sonstigen Anschluss zur Verfügung stellen.

Gemäß einer Ausführungsform ist das Erweiterungsmodul als Servicemodul eingerichtet und weist einen Datenspeicher sowie eine Speicherprozessierungseinheit auf. Die Speicherprozessierungseinheit ist dabei eingerichtet, an der zweiten Kommunikationseinheit empfangene Daten zu speichern und den Speicher zu verwalten. Messdaten können somit über einen längeren Zeitraum gespeichert werden. Der Datenspeicher kann ein eingebauter oder ein wechselbarer Speicher sein. Im Falle eines eingebauten Speichers kann der Speicher beispielsweise über eine weitere drahtlos-Kommunikationseinheit an eine Kommunikationseinheit außerhalb des Erweiterungsmoduls, z.B. einem Server oder einem Smartphone, übertragen werden. Die Daten können auch z.B. zu einem Erweiterungsmodul übertragen werden, das als Extern-Kommunikationsmodul eingerichtet ist, um die Daten z.B. in ein Netzwerk oder ein Smartphone zu übertragen.

Gemäß einer Ausführungsform ist das Erweiterungsmodul als Adaptermodul eingerichtet und weist eine Adaptereinheit auf, die eingerichtet ist, ein drahtgebundenes Sensorzusatzmodul aufzunehmen und die drahtlose Kommunikation mit der Sensorbasiseinheit und / oder drahtlose Energieübertragung von bzw. zu der Sensorbasiseinheit in eine drahtgebundene Kommunikation mit der Sensorbasiseinheit bzw. in eine drahtgebundene Energieübertragung von bzw. zu der Sensorbasiseinheit umzuwandeln. Somit kann ein vorhandenes Sensorzusatzmodul, das z.B. bis auf das Gehäuse ähnliche Eigenschaften wie die hier vorgestellten Erweiterungsmodule aufweisen kann, und das kontaktlos arbeitet, einfach z.B. in den Erweiterungsadapter eingeschoben werden. Durch einen Erweiterungsadapter kann somit ein übliches, kontaktlos arbeitendes Sensormodul auch verwendet werden, wenn die Sensorbasiseinheit keine zu dem Sensorzusatzmodul passenden, kontaktlosen Schnittstellen aufweist.

Gemäß einer weiteren Ausführungsform ist das Erweiterungsmodul als Kabelmodul eingerichtet und weist eine Schnittstelle zur drahtgebundenen externen Kommunikation und/oder externen Energieversorgung auf. Das Kabelmodul kann also drahtgebunden an eine externe Gleichspannungs- oder Wechselspannungsquelle angeschlossen werden, um somit Energie für die Sensorbasiseinheit oder ein weiteres Erweiterungsmodul zur Verfügung zu stellen.

Erfindunsgemäß wird eine Sensorvorrichtung bereitgestellt, die eine oben beschriebene Sensorbasiseinheit und ein oben beschriebenes Erweiterungsmodul aufweist, wobei das Erweiterungsmodul auf der Sensorbasiseinheit befestigt ist. Auf dem Erweiterungsmodul ist erfindungsgemäß ein weiteres Erweiterungsmodul befestigt.

Somit können quasi beliebig viele Erweiterungsmodule an die Sensorbasiseinheit angeschlossen werden. Dadurch wird eine Sensorvorrichtung zur Prozessgrößenermittlung mit einer Sensorbasiseinheit bereitgestellt, wobei die Sensorvorrichtung modular durch ein oder mehrere stapelbare Erweiterungsmodule erweiterbar ist. Gemäß einer Ausführungsform wird das erste Erweiterungsmodul an einer Seite der Sensorbasiseinheit angebracht und ist eingerichtet, das zweite Erweiterungsmodul als finales Erweiterungsmodul oder einen Stapel bildend weitere Erweiterungsmodule aufzunehmen. Zum Beispiel wird das erste Erweiterungsmodul an der Oberseite der Sensorbasiseinheit befestigt und das zweite Erweiterungsmodul an der Oberseite des ersten Erweiterungsmoduls, so dass ein Stapel an Erweiterungsmodulen aufgebaut wird, der sich senkrecht zur Oberfläche der Sensorbasiseinheit erstreckt. In diesem Fall liegen die Kommunikationsschnittstellen des ersten Erweiterungsmoduls auf gegenüberliegenden Seiten, z.B. oben und unten. Sind die Erweiterungsmodule zylindrisch, entsteht durch das Stapeln der Erweiterungsmodule ein zylindrischer Stapel mit runder Querschnittsfläche, bei dem sich die Gesamthöhe aus der Höhe der einzelnen Erweiterungsmodule ergibt. Die einzelnen Erweiterungsmodule können hierbei eine gleiche oder eine unterschiedliche Höhe aufweisen. Ein finales Erweiterungsmodul muss hierbei nicht notwendigerweise zwei mechanische bzw. Kommunikationsschnittstellen aufweisen. Ist das finale Erweiterungsmodul beispielsweise eine Anzeigen- und Bedieneinheit, würde möglicherweise ein weiteres Erweiterungsmodul das Lesen der Anzeige oder das Bedienen der Sensorvorrichtung be- oder verhindern.

Weitere Arten von Erweiterungsmodulen sind z.B. ein Sensormodul, bei dem das Erweiterungsmodul einen Beschleunigungssensor, einen Drucksensor, einen Erdmagnetfeldsensor, einen Gassensor, einen Abstandsensor, einen Helligkeitssensor und/oder einen Temperatursensor aufweisen kann. Abstandsensoren wie Lidar, Radar und Ultraschall sowie Bewegungssensoren und Helligkeitssensoren sind insbesondere in den finalen Erweiterungsmodulen zur Anwendung geeignet.

Andere Variationen der offenbarten Ausführungsformen können vom Fachmann bei der Durchführung der beanspruchten Erfindung durch das Studium der Zeichnungen, der Offenbarung und der beigefügten Ansprüche verstanden und ausgeführt werden. In den Ansprüchen schließt das Wort "umfassend" andere Elemente oder Schritte nicht aus, und der unbestimmte Artikel "ein" oder "eine" schließt eine Vielzahl nicht aus. Die bloße Tatsache, dass bestimmte Maßnahmen in voneinander abhängigen Ansprüchen angegeben sind, bedeutet nicht, dass eine Kombination dieser Maßnahmen nicht vorteilhaft genutzt werden kann. Bezugszeichen in den Ansprüchen sollten nicht so ausgelegt werden, dass sie den Umfang der Ansprüche begrenzen.

### Kurze Beschreibung der Figuren

Im Folgenden werden Ausführungsbeispiele der Erfindung mit Bezug auf die beiliegenden Figuren detailliert beschrieben. Weder die Beschreibung noch die Figuren sollen als die Erfindung einschränkend ausgelegt werden. Gleiche Bezugszeichen in unterschiedlichen Figuren bezeichnen gleiche Komponenten, sofern nicht ausdrücklich anders beschrieben. Hierbei zeigt
Fig. 1 ein Diagramm eines autarken Sensors,
Fig. 2 ein Diagramm eines Sensors mit integrierter Vor-Ort-Anzeige,
Fig. 3 ein Diagramm eines Sensors mit einem Photovoltaikmodul,
Fig. 4 ein Diagramm eine Sensorvorrichtung mit einer Sensorbasiseinheit und einem Erweiterungsmodul,
Fig. 5 Diagramme verschiedener Erweiterungsmodule,
Fig. 6 ein Diagramm eine mechanische Aufnahme für ein Erweiterungsmodul mit einer Winkelindikatoreinheit,
Fig. 7 ein Diagramm mit der erfindungsgemäßen Anordnung einer Sensorbasiseinheit und einem Stapel an Erweiterungsmodulen.

### Detaillierte Beschreibung der Figuren

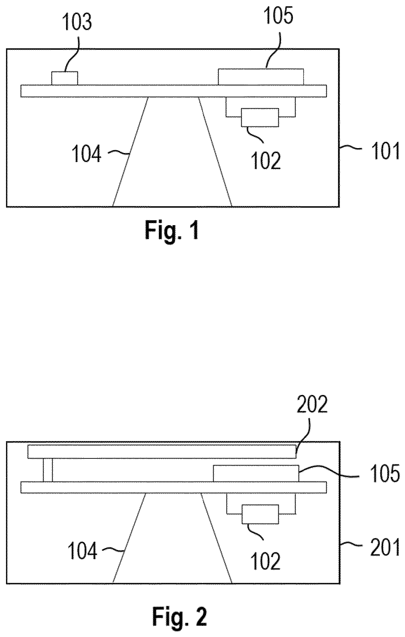

Fig. 1 bis Fig. 3 zeigen Beispiele von typischen Sensoren, die nicht nachträglich mit zusätzlichen Funktionen ausgestattet werden können.

Fig. 1 zeigt einen Sensor 101, der eine Batterie 102, einen Drahtloskommunikationsbaustein 103 sowie eine Füllstandermittlungseinheit 104 aufweist. Für Zwecke der Wartung und Vor-Ort-Bedienung weist der Sensor 101 darüber hinaus eine Nahfeldkommunikationseinheit 105, beispielsweise eine NFC-Einheit oder eine Bluetootheinheit, auf. Im Zusammenspiel der dargestellten Komponenten kann ein autarkes Messsystem realisiert werden.

Fig. 2 zeigt eine alternative Ausführung eines Sensors 201 mit integrierter Vor-Ort-Anzeige, beispielsweise einer LCD - Einheit 202 oder einer E-Paper-Einheit 202 mit einer Bedienfunktion. In dieser Ausführungsform kann die Nahfeldkommunikationseinheit 105 auch entfallen, da Anzeige und/oder Bedienung des Sensors direkt mit Hilfe der Einheit 202 vorgesehen sind.

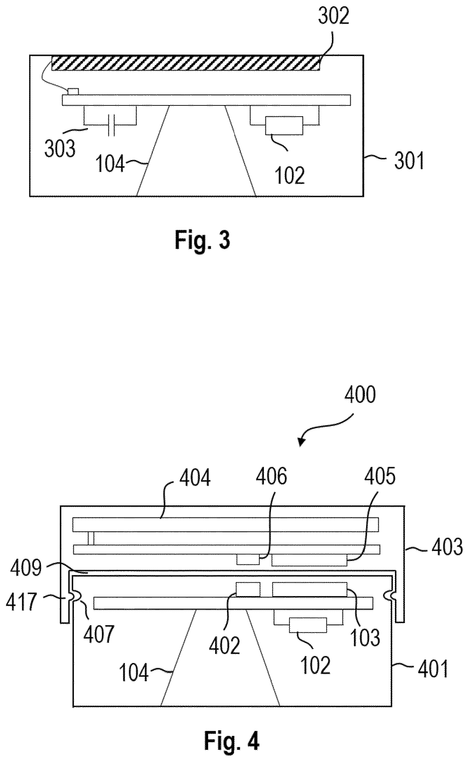

Bei den in Fig. 1 und Fig. 2 gezeigten Sensoren muss die komplette Sensoreinheit 101, 201 nach Entleerung der Batterie 102 ausgetauscht und entsorgt werden. Fig. 3 zeigt daher eine um eine Energy Harvesting Option 302, beispielsweise ein Photovoltaikmodul 302, erweiterte Version eines Sensors 301. Der Sensor 301 ist in der Lage, während sonnenreicher Tage hinweg Energie zu sammeln, und im Akkumulator 303 abzuspeichern. In sonnenärmeren Zeiten kann diese Energie dann genutzt werden, die Messung aufrechtzuerhalten, bevor im Falle eines Energiedefizits die Batterie 302 zur Messung verwendet werden muss. Hierdurch kann mit der Anordnung 301 die Lebenszeit des Sensors stark vergrößert werden kann. Allerdings liegen die Fertigungskosten des Sensors 301 deutlich über denen des Sensors 101.

Fig. 4 zeigt ein Beispiel eines Füllstandsensors 401 als Sensorbasiseinheit 401, der im Wesentlichen aus den bereits in Fig. 1 gezeigten Teilen Batterie 102, Drahtloskommunikationseinheit 104 und Füllstandermittlungseinheit 104 besteht, welche im Zusammenspiel eine autarke Füllstandmessung realisieren können. Das hermetisch dichte Gehäuse des Sensors 401 weist aber an seiner Außenseite eine mechanisch ausgebildete Aufnahmevorrichtung 408 bzw. Kontur 408 auf, welche geeignet ist, ein Erweiterungsmodul 403, hier ein Displaymodul 403 mit einer passenden Kontur 417 aufzunehmen. Das Erweiterungsmodul 403 ist ebenfalls hermetisch dicht konstruiert und somit auf einfache Art gegenüber äußeren Einflüssen geschützt. Zum Austausch von Energie zwischen dem autarken Füllstandsensor 401 und dem Erweiterungsmodul 403 dienen die drahtlos agierenden Energieübertragungseinheiten 103, 405. An dieser Stelle kommen typische Einheiten zum Einsatz, beispielsweise induktiv koppelnde Einheiten oder auch RFID-Standards wie NFC. Darüber hinaus weisen der Sensor 401 und das Erweiterungsmodul 403 jeweils zumindest eine drahtlose Kommunikationseinheit 402, 406 auf, welche zum Austausch von Steuerkommandos und / oder Daten eingerichtet sind. Anwendbare Standards nach dem Stand der Technik umfassen Bluetooth, Zigbee, RFID, NFC oder auch kapazitive Techniken zur bidirektionalen Kopplung oder auch optische Verfahren.

Das vorgestellte Ensemble von autarkem Füllstandsensor 401 und Erweiterungsmodul 403 ermöglicht im Beispiel der Fig. 4, einen Standardsensor 401 nachträglich oder bereits ab Werk mit einem zusätzlichen Display 404 auszustatten.

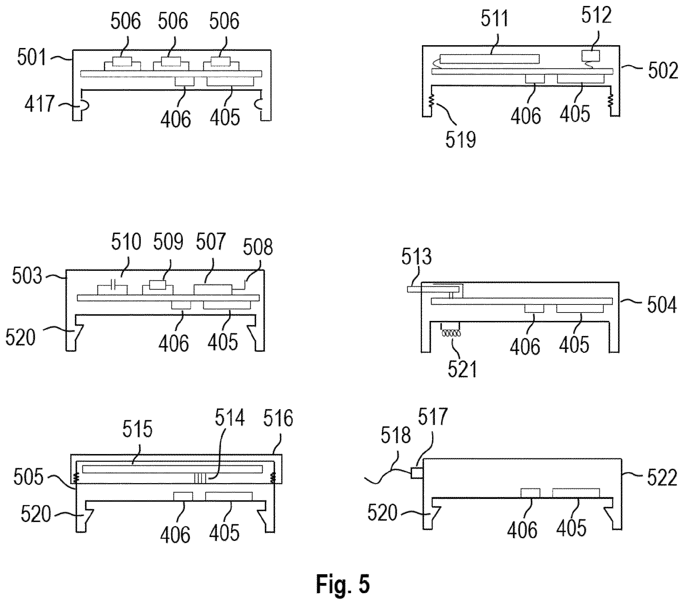

Das Prinzip der Erweiterung eines Basissensors 401 mit zusätzlichen Modulen 501, 502, 503, 504, 505, 522 wird in Fig. 5 weiter verfeinert. Allen gezeigten Beispielen ist eine Energieübertragungseinheit 405 und eine Kommunikationseinheit 406 gemein.

Das Energiemodul 501 beinhaltet einen oder mehrere Energiespeicher 506, welche geeignet sind, einem Basissensor 401 zusätzliche Energie bereitzustellen, und somit dessen Lebensdauer zu erhöhen.

Das Benutzerinterfacemodul 502 ist ausgestattet, mit Hilfe einer Displayeinheit 511 und / oder einer Eingabeeinheit 512 eine Vor-Ort-Bedienung des Basissensors 401 zu ermöglichen.

Das Kommunikationsmodul 503 ist geeignet, den Basissensor 401 mit zusätzlichen, drahtlosen Kommunikationsstandards zu erweitern, beispielsweise mit verschiedenen Low Power Standards wie LoRa, Sigfox, LPWAN, oder auch mit anderen Standards wie WLAN, GSM, 5G. Das Erweiterungsmodul 503 weist hierzu zumindest einen Kommunikationschip 507 sowie eine Antenne 508 auf. Je nach Ausführung kommen auch zusätzliche Energiespeicher 509 oder auch Energiepuffer 510 zur kurzfristigen Bereitstellung hoher Leistungen zum Einsatz.

Das Servicemodul 504 kann dazu verwendet werden, Langzeitaufzeichnungen betriebsrelevanter Daten eines Basissensors 401 zu erstellen, beispielsweise unter Verwendung fest eingebauter oder wechselbarer Speichermodule 513.

Das Adaptermodul 505 wandelt die drahtlos vom Basissensor übertragene Energie und Information in eine drahtgebundene Form um, und stellt diese an einer Schnittstelle 514 bereit. Diese Schnittstelle zum Anbringen drahtgebundener Ergänzungsmodule kann eine übliche Schnittstelle sein, und ermöglicht den Übergang zu gängigen, bereits vorhandenen, Ergänzungsmodulen. Das drahtgebundene Ergänzungsmodul 515 wird durch einen Deckel 516 des Adaptermoduls 505 hermetisch vor Umgebungseinflüssen geschützt.

Das Kabelmodul 522 schließlich kann immer dann verwendet werden, wenn ein autarker Basissensor 401 nachträglich doch noch drahtgebunden versorgt und/oder ausgewertet werden soll. Hierzu stellt das Kabelmodul 522 zumindest eine Schnittstelle 517 zum Anschluss eines Kabels 518 bereit, welches dem Sensor 401 zusätzliche Energie übermitteln kann und/oder Informationen wie zum Beispiel Messwerte, Softwareupdates, etc. aus dem Sensor auslesen oder in diesen von außen einbringen kann.

Die Beispiele der Fig. 5 zeigen auch unterschiedliche Beispiele für mechanische Konturen 417, 519, 520, 521 zur Befestigung des Erweiterungsmoduls am Basissensor 401. Denkbar ist hier die Verwendung von Gewindekonturen 519, Schnappkonturen 520 oder auch magnetischen Konturen 521 oder Klettkonturen 521. Es kann auch vorgesehen sein, den in Fig. 4 gezeigten Zwischenraum 409 zwischen Basissensor 401 und Erweiterungsmodul 403 durch Einbau einer Dichtung im Erweiterungsmodul gegen Schmutz und eindringende Feuchtigkeit nach außen hin abzudichten.

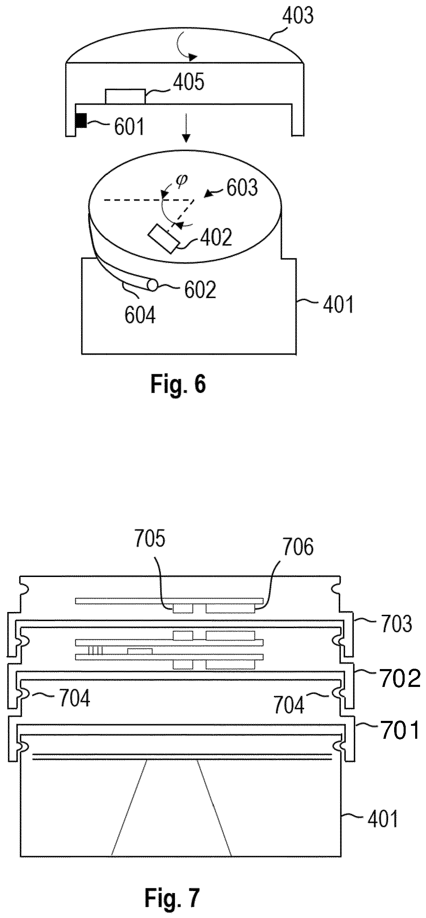

Fig. 6 zeigt eine weitere Weiterbildung der Konturen 407, 519, 520, 521. Zum Aufbau besonders kleiner, effizienter Kopplungselemente 402, 103, 406, 405 ist es notwendig, dass sich die Energieübertragungsbausteine 103, 405 und / oder die Kommunikationsbausteine 402, 406 nach Befestigung des Erweiterungsmoduls 403 im Wesentlichen gegenüberstehen. Hierdurch steigt die Effizienz bei der Energie und/oder Datenübertragung. Das Erweiterungsmodul 403 besitzt aus diesem Grunde eine Winkelindikatoreinheit 601, beispielsweise einen Stift 601, welcher während der Montage des Erweiterungsmoduls 403 auf dem Basissensor 401 in die Nut 604 eingreift. Die Nut bildet mit ihrem Endpunkt 602 im Zusammenspiel mit dem Winkelindikator 601 eine Winkelpositionierungseinheit aus, welche sicherstellt, dass der Montagewinkel 603 zwischen Basissensor 401 und Erweiterungsmodul 403 einem vordefinierten Sollwinkel 603 entspricht.

Dem Fachmann sind an dieser Stelle weitere mechanische Vorrichtungen bekannt, welche eine vordefinierte Winkellage nach erfolgter Montage sicherstellen können.

Fig. 7 zeigt eine erfindungegemäße Ausgestaltung der Sensorvorrichtung 400 mit den Erweiterungsmodulen 701, 702, 703, mit der ein Aufstapeln mehrerer Module erreicht wird.

Hierdurch kann die Sensorbasiseinheit 401 um mehrere Funktionen erweitert werden, wobei Zwischenmodule 701, 702 jeweils auch als finale Erweiterungsmodule bzw. Endmodule 703 verwendet werden können. Als Zwischenmodule können insbesondere Energiemodule 501, Kommunikationsmodule 503, Servicemodule 504 oder auch Kabelmodule 522 verwendet werden. Zwischenmodule 701, 702 sind dadurch gekennzeichnet, dass sie zum einen mechanische Aufnahmen 704 zur Befestigung weiterer Erweiterungsmodule aufweisen, aber auch geeignete Kommunikationseinheiten 705 und/oder Energieübertragungseinheiten 706 besitzen, die dem Anbinden weiterer Erweiterungsmodule dienen.

Als Endmodule 703 können grundsätzlich alle bislang vorgestellten Erweiterungsmodule verwendet werden, insbesondere auch die Zwischenmodule 701, 702. Naheliegend ist, dass insbesondere Module mit Photovoltaikelementen oder Anzeige- und Bedienelementen vorrangig als Endmodul 703 ausgeführt werden.

## Patentansprüche

1. Sensorvorrichtung (400), aufweisend eine autarke Sensorbasiseinheit (401) zur Prozessgrößenermittlung im industriellen Umfeld und mindestens ein erstes Erweiterungsmodul (403), das auf der Sensorbasiseinheit (401) befestigt werden kann, und ein weiteres Erweiterungsmodul; wobei die autarke Sensorbasiseinheit (401), aufweist:
eine erste drahtlose Kommunikationseinheit (402), eingerichtet sowohl zum Senden von Signalen zu dem ersten Erweiterungsmodul (701) und / oder Empfangen von Signalen von dem ersten Erweiterungsmodul (701) als auch zum Senden von Signalen zu dem weiteren Erweiterungsmodul (702, 703) und / oder Empfangen von Signalen von dem weiteren Erweiterungsmodul (702);
und/oder eine erste drahtlose Energieübertragungseinheit (103), eingerichtet sowohl zum Senden von Energie zu dem ersten Erweiterungsmodul (701) und / oder Empfangen von Energie von dem ersten Erweiterungsmodul (701) als auch zum Senden von Energie zu dem weiteren Erweiterungsmodul (702, 703) und / oder Empfangen von Energie von dem weiteren Erweiterungsmodul (702, 703);
ein erstes Gehäuse mit einer ersten Aufnahmevorrichtung (407), eingerichtet zum Aufnehmen des ersten Erweiterungsmoduls (701), wobei das erste Gehäuse die Sensorbasiseinheit (401) vollständig umschließt;
und wobei das erste Erweiterungsmodul (701) aufweist:
eine zweite drahtlose Kommunikationseinheit (406), eingerichtet zum Senden von Signalen zu der Sensorbasiseinheit (401) und / oder Empfangen von Signalen von der Sensorbasiseinheit (401); und
ein zweites Gehäuse mit einer zweiten Aufnahmevorrichtung (417), die passend zur ersten Aufnahmevorrichtung (407) ausgestaltet ist, so dass das erste Erweiterungsmodul (403) von der Sensorbasiseinheit (401) aufgenommen werden kann, und einer dritten Aufnahmevorrichtung, zur Aufnahme des weiteren Erweiterungsmoduls, wobei das zweite Gehäuse das erste Erweiterungsmodul (701) vollständig umschließt; und
wobei das weitere Erweiterungsmodul aufweist:
eine dritte drahtlose Kommunikationseinheit, eingerichtet zum Senden von Signalen zu der Sensorbasiseinheit und/oder Empfangen von Signalen von der Sensorbasiseinheit;
und ein drittes Gehäuse mit einer weiteren Aufnahmevorrichtung, die passend zur dritten Aufnahmevorrichtung (407) ausgestaltet ist, so dass das weitere Erweiterungsmodul von dem ersten Erweiterungsmodul aufgenommen werden kann, wobei das dritte Gehäuse das weitere Erweiterungsmodul vollständig umschließt;
und wobei das erste Erweiterungsmodul und das weitere Erweiterungsmodul unterschiedliche Baugruppen, Bauteile, Schnittstellen, und/oder Funktionalitäten aufweisen.

2. Sensorvorrichtung (400) nach Anspruch 1, wobei das erste Gehäuse die Sensorbasiseinheit (401) hermetisch umschließt.

3. Sensorvorrichtung (400) nach Anspruch 1 oder 2, wobei die Signale Mess- und/oder Steuersignale sind, und die erste drahtlose Kommunikationseinheit (402) eingerichtet ist, die Signale analog oder digital zu senden und / oder zu empfangen.

4. Sensorvorrichtung (400) nach einem der vorhergehenden Ansprüche, wobei die erste drahtlose Energieübertragungseinheit (103) eingerichtet ist, elektrische Energie induktiv oder elektroakustisch zu senden.

5. Sensorvorrichtung (400) nach einem der Ansprüche 1-3, wobei die erste drahtlose Energieübertragungseinheit (103) eingerichtet ist, elektrische Energie induktiv oder elektroakustisch zu empfangen.

6. Sensorvorrichtung (400) nach einem der vorhergehenden Ansprüche, wobei das zweite Gehäuse (421) das erste Erweiterungsmodul (701) hermetisch umschließt.

7. Sensorvorrichtung (400) nach einem der vorhergehenden Ansprüche, wobei die Signale Mess- und/oder Steuersignale sind, und die zweite drahtlose Kommunikationseinheit (406) eingerichtet ist, die Signale analog oder digital zu senden und / oder zu empfangen.

8. Sensorvorrichtung (400) nach einem der vorhergehenden Ansprüche, wobei das erste Erweiterungsmodul (701) oder das zweite Erweiterungsmodul (702,703) weiterhin eine zweite drahtlose Energieübertragungseinheit (405) aufweist, die zum Senden von Energie zu der Sensorbasiseinheit (401) und / oder Empfangen von Energie von der Sensorbasiseinheit (401) eingerichtet ist.

9. Sensorvorrichtung (400) nach Anspruch 8, wobei die zweite drahtlose Energieübertragungseinheit (405) eingerichtet ist, elektrische Energie induktiv zu senden und/oder zu empfangen.

10. Sensorvorrichtung (400) nach einem der vorhergehenden Ansprüche, wobei das erste Erweiterungsmodul (701) oder zweite Erweiterungsmodul (, 702, 703)
als Energiemodul (501) eingerichtet ist und mindestens einen Energiespeicher (506) aufweist; oder
als Anzeige- und/oder Bedienmodul (502) eingerichtet ist und eine Anzeigen- (511) und/oder Bedieneinheit (512) aufweist; oder
als Extern-Kommunikationsmodul (503) eingerichtet ist und eine dritte Kommunikationseinheit (507) aufweist; oder
als Servicemodul (504) eingerichtet ist und einen Datenspeicher (513) und eine Speicherprozessierungseinheit aufweist, wobei die Speicherprozessierungseinheit eingerichtet ist, an der zweiten Kommunikationseinheit (406) empfangene Daten zu speichern und den Datenspeicher (513) zu verwalten; oder
als Adaptermodul (505) eingerichtet ist und eine Adaptereinheit (516) aufweist, die eingerichtet ist, ein drahtgebundenes Sensorzusatzmodul (515) aufzunehmen und die drahtlose Kommunikation mit der Sensorbasiseinheit (401) und / oder drahtlose Energieübertragung von bzw. zu der Sensorbasiseinheit (401) in eine drahtgebundene Kommunikation mit der Sensorbasiseinheit (401) bzw. in eine drahtgebundene Energieübertragung von bzw. zu der Sensorbasiseinheit (401) umzuwandeln; oder
als Kabelmodul (522) eingerichtet ist und eine Schnittstelle (518) zur drahtgebundenen externen Kommunikation und/oder externen Energieversorgung aufweist.

## Claims

1. A sensor device (400), comprising a self-sufficient sensor base unit (401) for determining process variables in an industrial environment and at least one first expansion module (403), which can be attached to the sensor base unit (401), and a further expansion module; wherein the self-sufficient sensor base unit (401) comprises:
a first wireless communication unit (402), configured both to transmit signals to the first expansion module (701) and/or receive signals from the first expansion module (701) and to transmit signals to the further expansion module (702, 703) and/or to receive signals from the further expansion module (702)
and/or a first wireless power transmission unit (103), configured both to transmit power to the first expansion module (701) and/or to receive power from the first expansion module (701) and to transmit power to the further expansion module (702, 703) and/or to receive power from the further expansion module (702, 703);
a first housing with a first receiving device (407), configured to receive the first expansion module (701), wherein the first housing completely encloses the sensor base unit (401);
and wherein the first expansion module (701) comprises:
a second wireless communication unit (406) configured to transmit signals to the sensor base unit (401) and/or receive signals from the sensor base unit (401); and
a second housing having a second receiving device (417) configured to match the first receiving device (407) so that the first expansion module (403) can be received by the sensor base unit (401), and a third receiving device for receiving the further expansion module, wherein the second housing completely encloses the first expansion module (701); and
whereby the further expansion module comprises:
a third wireless communication unit configured to transmit signals to the sensor base unit and/or receive signals from the sensor base unit;
and a third housing with a further receiving device, which is designed to match the third receiving device (704), so that the further expansion module can be received by the first expansion module, wherein the third housing completely encloses the further expansion module;
and wherein the first expansion module and the further expansion module have different assemblies, components, interfaces and/or functionalities.

2. The sensor device (400) according to claim 1, wherein the first housing hermetically encloses the sensor base unit (401).

3. The sensor device (400) according to claim 1 or 2, wherein the signals are measurement and/or control signals, and the first wireless communication unit (402) is configured to transmit and/or receive the signals in analogue or digital form.

4. The sensor device (400) according to any one of the preceding claims, wherein the first wireless energy transmission unit (103) is configured to transmit electrical energy inductively or electroacoustically.

5. The sensor device (400) according to any one of claims 1-3, wherein the first wireless energy transmission unit (103) is configured to receive electrical energy inductively or electroacoustically.

6. The sensor device (400) according to any one of the preceding claims, wherein the second housing (421) hermetically encloses the first expansion module (701).

7. The sensor device (400) according to one of the preceding claims, wherein the signals are measurement and/or control signals, and the second wireless communication unit (406) is configured to transmit and/or receive the signals in analogue or digital form.

8. The sensor device (400) according to one of the preceding claims, wherein the first expansion module (701) or the second expansion module (702, 703) further comprises a second wireless power transmission unit (405) configured to transmit power to the sensor base unit (401) and/or receive power from the sensor base unit (401).

9. The sensor device (400) according to claim 8, wherein the second wireless energy transmission unit (405) is configured to transmit and/or receive electrical energy inductively.

10. The sensor device (400) according to one of the preceding claims, wherein the first expansion module (701) or second expansion module (702, 703)
is an energy module (501) and has at least one energy store (506); or
is a display and/or operating module (502) and has a display (511) and/or operating unit (512); or
is an external communication module (503) and has a third communication unit (507); or
is a service module (504) and comprises a data memory (513) and a memory processing unit, wherein the memory processing unit is configured to store data received at the second communication unit (406) and to manage the data memory (513); or
is an adapter module (505) and comprises an adapter unit (516) which is configured to receive a wired sensor add-on module (515) and to convert the wireless communication with the sensor base unit (401) and/or wireless energy transmission from or to the sensor base unit (401) into a wired communication with the sensor base unit (401) or into a wired energy transmission from or to the sensor base unit (401); or
is a cable module (522) and comprises an interface (518) for wired external communication and/or external power supply.

## Revendications

1. Dispositif capteur (400), présentant une unité de base de capteur autonome (401) pour la détermination de grandeurs de processus dans l'environnement industriel et au moins un premier module d'extension (403) qui peut être fixé sur l'unité de base de capteur (401), et un autre module d'extension ; dans lequel l'unité de base de capteur autonome (401) présente :
une première unité de communication sans fil (402), conçue aussi bien pour envoyer des signaux au premier module d'extension (701) et/ou recevoir des signaux du premier module d'extension (701) que pour envoyer des signaux à l'autre module d'extension (702, 703) et/ou recevoir des signaux de l'autre module d'extension (702) ;
et/ou une première unité de transmission d'énergie sans fil (103), conçue aussi bien pour envoyer de l'énergie au premier module d'extension (701) et/ou recevoir de l'énergie du premier module d'extension (701) que pour envoyer de l'énergie à l'autre module d'extension (702, 703) et/ou recevoir de l'énergie de l'autre module d'extension (702, 703) ;
un premier boîtier avec un premier dispositif d'accueil (407), conçu pour accueillir le premier module d'extension (701), dans lequel le premier boîtier entoure complètement l'unité de base de capteur (401) ;
et dans lequel le premier module d'extension (701) présente :
une deuxième unité de communication sans fil (406), conçue pour envoyer des signaux à l'unité de base de capteur (401) et/ou recevoir des signaux de l'unité de base de capteur (401) ; et
un deuxième boîtier avec un deuxième dispositif d'accueil (417) qui est conçu pour s'adapter au premier dispositif d'accueil (407), de sorte que le premier module d'extension (403) puisse être accueilli par l'unité de base de capteur (401), et un troisième dispositif d'accueil, pour accueillir l'autre module d'extension, dans lequel le deuxième boîtier entoure complètement le premier module d'extension (701) ; et
dans lequel l'autre module d'extension présente :
une troisième unité de communication sans fil, conçue pour envoyer des signaux à l'unité de base de capteur et/ou recevoir des signaux de l'unité de base de capteur ;
et un troisième boîtier avec un autre dispositif d'accueil qui est conçu pour s'adapter au troisième dispositif d'accueil (407), de sorte que l'autre module d'extension puisse être accueilli par le premier module d'extension, dans lequel le troisième boîtier entoure complètement l'autre module d'extension ;
et dans lequel le premier module d'extension et l'autre module d'extension présentent des sous-ensembles, des composants, des interfaces et/ou des fonctionnalités différents.

2. Dispositif capteur (400) selon la revendication 1, dans lequel le premier boîtier entoure hermétiquement l'unité de base de capteur (401).

3. Dispositif capteur (400) selon la revendication 1 ou 2, dans lequel les signaux sont des signaux de mesure et/ou de commande, et la première unité de communication sans fil (402) est conçue pour envoyer et/ou recevoir les signaux sous forme analogique ou numérique.

4. Dispositif capteur (400) selon l'une des revendications précédentes, dans lequel la première unité de transmission d'énergie sans fil (103) est conçue pour envoyer de l'énergie électrique par induction ou par voie électroacoustique.

5. Dispositif capteur (400) selon l'une des revendications 1 à 3, dans lequel la première unité de transmission d'énergie sans fil (103) est conçue pour recevoir de l'énergie électrique par induction ou par voie électroacoustique.

6. Dispositif capteur (400) selon l'une des revendications précédentes, dans lequel le deuxième boîtier (421) entoure hermétiquement le premier module d'extension (701).

7. Dispositif capteur (400) selon l'une des revendications précédentes, dans lequel les signaux sont des signaux de mesure et/ou de commande, et la deuxième unité de communication sans fil (406) est conçue pour envoyer et/ou recevoir les signaux sous forme analogique ou numérique.

8. Dispositif capteur (400) selon l'une des revendications précédentes, dans lequel le premier module d'extension (701) ou le deuxième module d'extension (702, 703) présente en outre une deuxième unité de transmission d'énergie sans fil (405) qui est conçue pour envoyer de l'énergie à l'unité de base de capteur (401) et/ou recevoir de l'énergie de l'unité de base de capteur (401).

9. Dispositif capteur (400) selon la revendication 8, dans lequel la deuxième unité de transmission d'énergie sans fil (405) est conçue pour envoyer et/ou recevoir de l'énergie électrique par induction.

10. Dispositif capteur (400) selon l'une des revendications précédentes, dans lequel le premier module d'extension (701) ou le deuxième module d'extension (702, 703) est conçu comme module d'énergie (501) et présente au moins un accumulateur d'énergie (506) ; ou
est conçu comme module d'affichage et/ou de commande (502) et présente une unité d'affichage (511) et/ou de commande (512) ; ou
est conçu comme module de communication externe (503) et présente une troisième unité de communication (507) ; ou est conçu comme module de service (504) et présente une mémoire de données (513) et une unité de traitement de mémoire, dans lequel l'unité de traitement de mémoire est conçue pour stocker les données reçues par la deuxième unité de communication (406) et pour gérer la mémoire de données (513) ; ou
est conçu comme module adaptateur (505) et présente une unité d'adaptation (516) qui est conçue pour accueillir un module capteur supplémentaire filaire (515) et pour convertir la communication sans fil avec l'unité de base de capteur (401) et/ou la transmission d'énergie sans fil depuis ou vers l'unité de base de capteur (401) en une communication filaire avec l'unité de base de capteur (401) ou en une transmission d'énergie filaire depuis ou vers l'unité de base de capteur (401) ; ou
est conçu comme module à câble (522) et présente une interface (518) pour la communication externe filaire et/ou l'alimentation en énergie externe.
